(19) Europäisches Patentamt
European Patent Office
Office européen des brevets

(11) EP 2 053 739 A1

(12) **EUROPEAN PATENT APPLICATION**
published in accordance with Art. 153(4) EPC

(43) Date of publication:
**29.04.2009 Bulletin 2009/18**

(51) Int Cl.:
*H03G 3/20* (2006.01)   *H03G 3/30* (2006.01)

(21) Application number: **07850217.6**

(22) Date of filing: **06.12.2007**

(86) International application number:
**PCT/JP2007/073608**

(87) International publication number:
**WO 2008/072553 (19.06.2008 Gazette 2008/25)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **15.12.2006 JP 2006338381**

(71) Applicant: **Panasonic Corporation**
**Kadoma-shi**
**Osaka 571-8501 (JP)**

(72) Inventor: **HASEGAWA, Teruaki**
**Osaka-shi**
**Osaka 540-6207 (JP)**

(74) Representative: **Grünecker, Kinkeldey,**
**Stockmair & Schwanhäusser**
**Anwaltssozietät**
**Leopoldstraße 4**
**80802 München (DE)**

(54) **DIGITAL AGC DEVICE**

(57)    To keep the average amplitude of a signal substantially constant, a digital AGC device includes: a first multiplier for multiplying an in-phase signal and a filter output signal together and outputting a result of the multiplication; a second multiplier for multiplying a quadrature signal and the filter output signal together and outputting a result of the multiplication; a determination unit for making an enable signal valid and outputting the enable signal when the outputs from the first and second multipliers satisfy a condition defined according to a threshold signal; a sum-of-square averaging unit for obtaining and outputting a time average of a sum of squares of the respective outputs from the first and second multipliers when the enable signal is valid; a subtractor for obtaining and outputting a difference between a reference signal and the operation result of the sum-of-square averaging unit; and a loop filter for smoothing the output from the subtractor and outputting the smoothed output as the filter output signal.

FIG. 7

**Description**

**TECHNICAL FIELD**

The present invention relates to digital automatic gain control (AGC) devices for use in digital demodulation of digital-modulated signals.

**BACKGROUND ART**

With recent video digitalization, digital broadcasting of satellite broadcasting, CATV, and terrestrial broadcasting has begun in various countries. As a transmission method for such digital broadcasting, a method suitable for characteristics of the transmission channel is adopted for each type of broadcasting. For example, a vestigial-sideband (VSB) modulation method is employed for terrestrial digital broadcasting in the United States. For processing of digital modulated signals used in such broadcasting, a digital AGC circuit for performing digital processing on a signal subjected to AD conversion in order to maintain constant average amplitude is known (see, for example, Patent Document 1).
Patent Document 1: Japanese Laid-Open Patent Publication No. 2-237207 (Figure 3).

**DISCLOSURE OF INVENTION**

**PROBLEM THAT THE INVENTION IS TO SOLVE**

However, there has been a drawback in which the average amplitude of a signal output from a digital AGC is not constant under some conditions of a transmission channel (e.g., in the presence of a reflected signal). With this drawback, the performance of a demodulator circuit using a signal subjected to digital AGC processing degrades.
It is therefore an object of the present invention to keep an average amplitude of a signal substantially constant, independently of characteristics of a transmission channel.

**MEANS OF SOLVING THE PROBLEM**

A first digital AGC device according to the present invention includes: a first multiplier for multiplying an in-phase signal and a filter output signal together and outputting a result of the multiplication; a second multiplier for multiplying a quadrature signal and the filter output signal together and outputting a result of the multiplication; a determination unit for making an enable signal valid and outputting the enable signal when the outputs from the first and second multipliers satisfy a condition defined according to a threshold signal; a sum-of-square averaging unit for obtaining and outputting a time average of a sum of squares of the respective outputs from the first and second multipliers when the enable signal is valid; a subtractor for obtaining and outputting a difference between a reference signal and the operation result of the sum-of-square averaging unit; and a loop filter for smoothing the output from the subtractor and outputting the smoothed output as the filter output signal.
In this device, when the outputs from the first and second multipliers do not satisfy given conditions, these outputs are not reflected in the average sum of squares. Thus, even in the presence of, for example, a reflected signal, it is possible to keep the average amplitude of an output signal from the digital AGC device substantially constant.
A second digital AGC device according to the present invention includes: a first multiplier for multiplying an in-phase signal and a filter output signal together and outputting a result of the multiplication; a second multiplier for multiplying a quadrature signal and the filter output signal together and outputting a result of the multiplication; a channel quality estimating unit for obtaining channel quality based on at least one of the outputs from the first and second multipliers; a reference signal generator for generating a reference signal based on the channel quality; a sum-of-square averaging unit for obtaining and outputting a time average of a sum of squares of the respective outputs from the first and second multipliers; a subtractor for obtaining and outputting a difference between the reference signal and the operation result of the sum-of-square averaging unit; and a loop filter for smoothing the output from the subtractor and outputting the smoothed output as the filter output signal.
In this device, the reference signal is generated based on the channel quality. Thus, even in the presence of, for example, a reflected signal, it is possible to keep the average amplitude of an output signal from the digital AGC device substantially constant.

**EFFECT OF THE INVENTION**

According to the present invention, the average amplitude of an output signal from a digital AGC device is kept substantially constant. Thus, the amplitude of the output signal does not excessively increase, resulting in preventing degradation of the performance of a demodulator circuit using this output signal.

**BRIEF DESCRIPTION OF DRAWINGS**

[FIG. 1] FIG. 1 is a block diagram showing a configuration of a demodulator including a digital AGC device according to a first embodiment of the present invention.

[FIG. 2] FIG. 2 is an explanation table showing values of a received signal in the presence of a reflected signal.

[FIG. 3] FIG. 3 is an explanation table showing values of a signal subjected to gain control by an analog AGC unit in the presence of a reflected signal.

[FIG. 4] FIG. 4 is an explanation table showing values of a signal subjected to gain control by the analog AGC unit in the absence of a reflected signal.

[FIG. 5] FIG. 5 is a graph showing distribution of signal points in the presence of a reflected signal (in the case of FIG. 3).

[FIG. 6] FIG. 6 is a graph showing distribution of signal points in the absence of a reflected signal (in the case of FIG. 4).

[FIG. 7] FIG. 7 is a block diagram showing a configuration of the digital AGC device according to the first embodiment.

[FIG. 8] FIG. 8 is a graph showing an example of signal points and threshold values of a determination unit shown in FIG. 7.

[FIG. 9] FIG. 9 is a block diagram showing a configuration of a digital AGC device according to a second embodiment of the present invention.

[FIG. 10] FIG. 10 is a graph for explaining generation of a reference signal REF.

**BRIEF EXPLANATION OF REFERENCE NUMERALS**

| 26, 226 | digital AGC device |
| 31 | first multiplier |
| 32 | second multiplier |
| 34, 234 | sum-of-square averaging unit |
| 35 | subtractor |
| 36 | loop filter |
| 38 | determination unit |
| 48 | channel quality estimating unit |
| 49 | reference signal generator |

BEST MODE FOR CARRYING OUT THE INVENTION

Hereinafter, embodiments of the present invention will be described with reference to the drawings.

(EMBODIMENT 1)

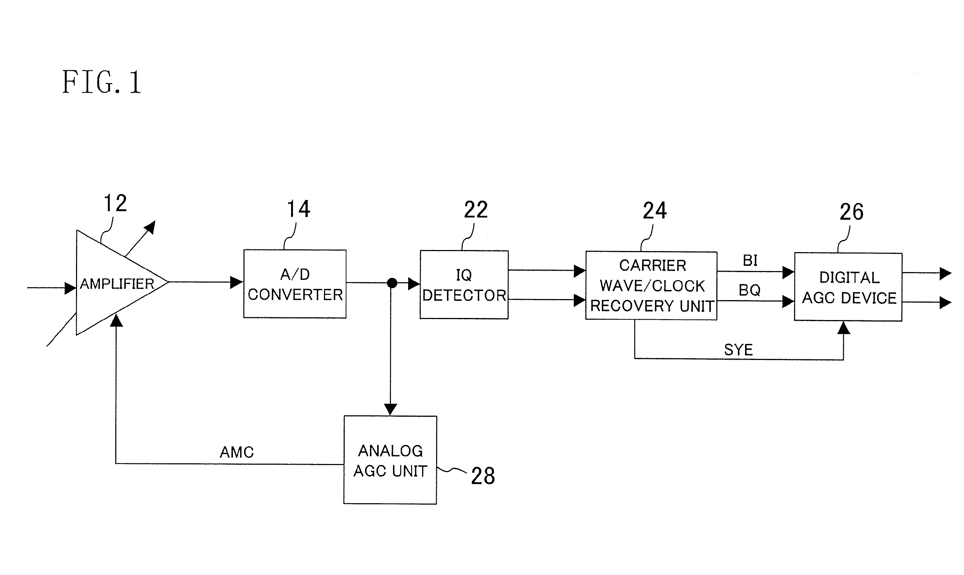

FIG. 1 is a block diagram showing a configuration of a demodulator including a digital AGC device according to a first embodiment of the present invention. The demodulator shown in FIG. 1 includes an amplifier 12, an A/D converter 14, an IQ detector 22, a carrier wave/clock recovery unit 24, a digital AGC device 26, and an analog AGC unit 28.

The amplifier 12 amplifies a received signal and outputs the amplified signal to the A/D converter 14, according to an amplifier control signal AMC. The A/D converter 14 converts the received signal into a digital signal and outputs the digital signal to the IQ detector 22 and the analog AGC unit 28. The analog AGC unit 28 generates and outputs the amplifier control signal AMC. The amplifier 12, the A/D converter 14, and the analog AGC unit 28 form a negative feedback loop to adjust the gain of the amplifier 12. Thus, the time average value of amplitude (average amplitude) of an input signal to the A/D converter 14 is kept substantially constant.

The IQ detector 22 performs quadrature detection on the output from the A/D converter 14 and outputs an in-phase signal and a quadrature signal. The carrier wave/clock recovery unit 24 performs digital demodulation on the in-phase signal and the quadrature signal, and outputs a result of the demodulation as an in-phase signal BI and a quadrature signal BQ to the digital AGC device 26. The carrier wave/clock recovery unit 24 also generates a symbol enable signal SYE and outputs the symbol enable signal SYE to the digital AGC device 26. The digital AGC device 26 keeps average amplitudes of the in-phase signal BI and the quadrature signal BQ substantially constant. At this time, the digital AGC device 26 follows an amplitude variation which the analog AGC unit 28 cannot follow.

Now, a case where an 8-level VSB (8-VSB) modulated signal is received and input to the amplifier **12** is described as an example. The position represented by a symbol of the 8-VSB modulated signal is normalized to be one of the followings:

$$(I, Q) = (-1, Q1), (-3, Q2), (-5, Q3), (-7, Q4), (1, Q5), (3, Q6), (5, Q7), (7, Q8)$$

Suppose there is a reflected signal having the same magnitude as a main signal and has a delay of +T (where T is a symbol interval) with respect to the main signal. Since the received signal is an 8-VSB modulated signal, information on the Q axis components are ignored and I axis values are considered as signal values. The demodulator shown in FIG. **1** receives a signal in which the reflected signal is added to the main signal so that it is considered that the level of the reflected signal is added to the level of the main signal.

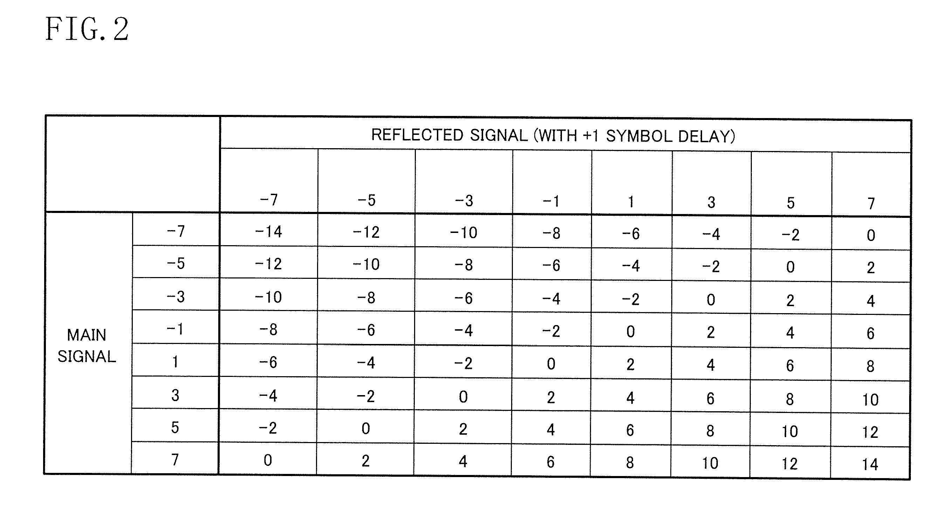

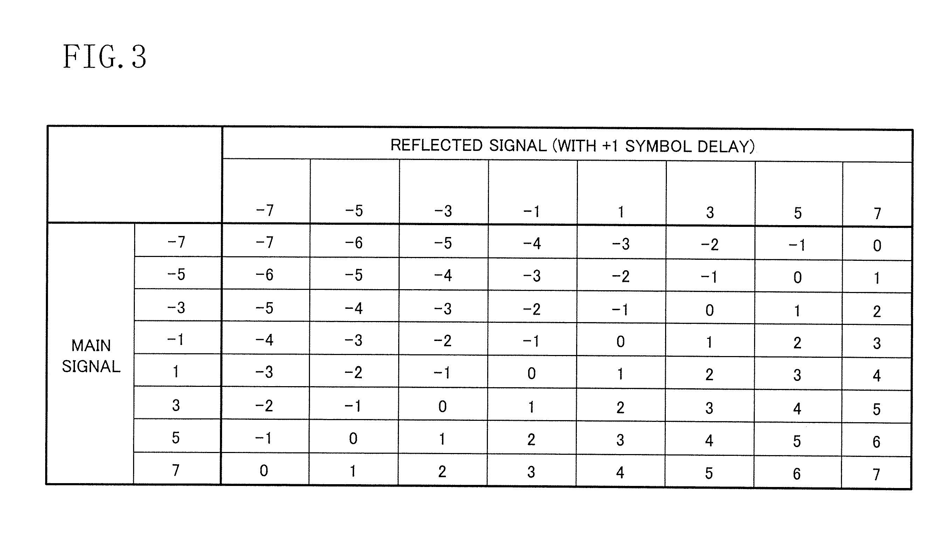

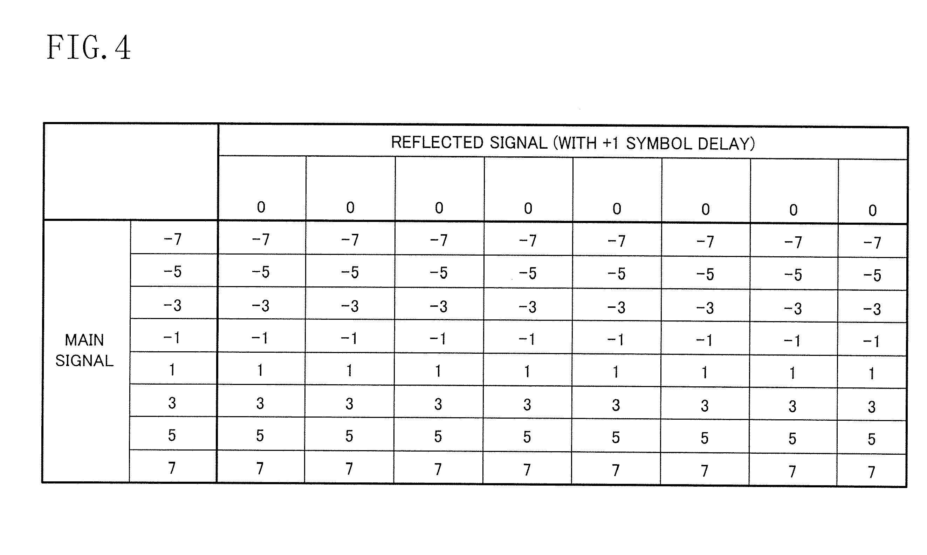

FIG. **2** is an explanation table showing values of a received signal in the presence of a reflected signal. FIG. **3** is an explanation table showing values of a signal subjected to gain control by the analog AGC unit **28** in the presence of a reflected signal. FIG. **4** is an explanation table showing values of a signal subjected to gain control by the analog AGC unit **28** in the absence of a reflected signal. It is assumed that the probabilities of occurrence of eight levels represented by the 8-VSB modulated signal are the same.

FIGS. **2** through **4** show the values of a received signal with combination of the values of a main signal and the levels of a reflected signal. The values of a signal input to the demodulator shown in FIG. **1** are shown in FIG. **2**. Since control by the analog AGC unit 28 keeps the average amplitude of the signal constant, the signal after the control has values as shown in FIG. **3**.

In FIGS. **3** and **4**, each value is squared and the sum of these squared values (i.e., the sum of squares) is obtained. The obtained values are:

Z3 = 672

Z4=1344

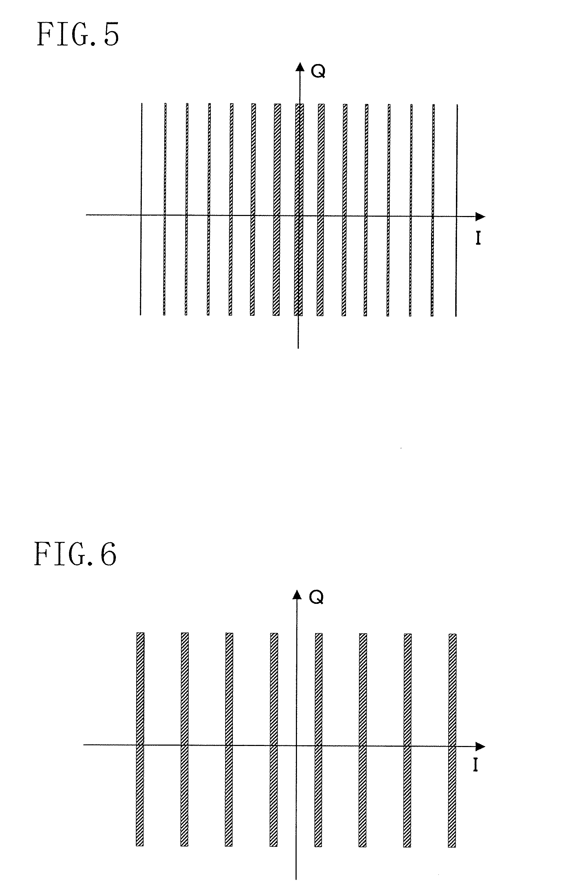

where Z3 and Z4 are the sums of squares in FIGS. **3** and **4**, respectively. These values show that the sum Z3 of squares in the presence of a reflected signal is smaller than the sum Z4 of squares in the absence of a reflected signal. This is because signal points are concentrated around the center of the IQ complex plane under the influence of the reflected signal. FIG. **5** is a graph showing distribution of signal points in the presence of a reflected signal (in the case of FIG. **3**). FIG. **6** is a graph showing distribution of signal points in the absence of a reflected signal (in the case of FIG. **4**).

Suppose a reference signal is obtained from the time average value of the sum of squares for all the symbols and digital AGC processing is performed, the negative feedback loop for performing the digital AGC processing is controlled to increase a signal more than necessary in the presence of a reflected signal. This is because the sum of squares is estimated to be small in the presence of a reflected signal as explained with reference to FIG. **3** even if an optimum reference signal is used in the absence of a reflected signal.

Consequently, the value of the 8-VSB modulated signal exceeds a value represented by an effective bit width, so that the 8-VSB modulated signal is clipped. Thus, a non-linear component is created, resulting in degrading demodulation performance after the digital AGC processing. In view of this, the digital AGC device **26** is configured in the following manner.

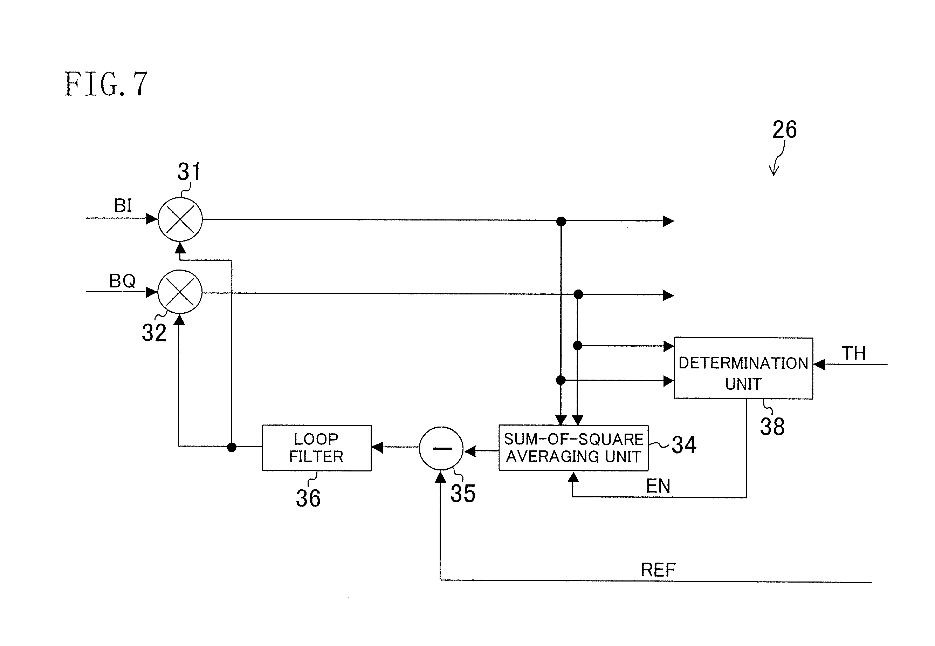

FIG. **7** is a block diagram showing a configuration of the digital AGC device 26 according to the first embodiment. The digital AGC device **26** shown in FIG. 1 includes a first multiplier **31**, a second multiplier **32**, a sum-of-square averaging unit **34**, a subtractor **35**, a loop filter **36**, and a determination unit **38**. The multipliers **31** and **32** respectively receive an in-phase signal BI and a quadrature signal BQ both of which are base band signals. The multiplier **31** multiplies the in-phase signal BI and an output from the loop filter **36** together and outputs the result as an in-phase signal GI subjected to gain control. The multiplier **32** multiplies the quadrature signal BQ and an output from the loop filter **36** together, and outputs the result as a quadrature signal GQ subjected to gain control.

When the in-phase signal GI and the quadrature signal GQ satisfy conditions defined according to a threshold signal TH, the determination unit **38** makes an enable signal EN valid and outputs the signal to the sum-of-square averaging unit **34**. If the enable signal is valid, the sum-of-square averaging unit **34** squares each of the in-phase signal GI and the quadrature signal GQ, obtains the sum of these squares, averages the sum in terms of time, and outputs the averaged sum of squares to the subtractor **35**.

The subtractor 35 reduces a reference signal REF from the averaged sum of squares and outputs the obtained error to the loop filter **36**. The loop filter **36** smoothes the error and outputs the result to the multipliers 31 and **32**. Specifically, the loop filter **36** multiplies the error by a given coefficient "α", performs integral operation, and outputs the result to the multipliers **31** and **32**.

In this manner, the digital AGC device **26** controls the gain with respect to the in-phase signal BI and the quadrature signal BQ such that the error output from the subtractor **35** approaches zero, and operates to keep the average amplitude of the output signal substantially constant.

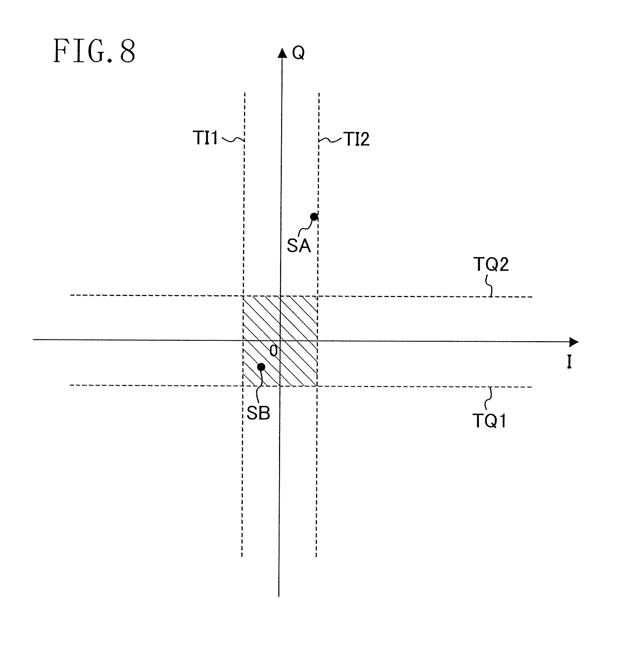

FIG. **8** is a graph showing an example of signal points and threshold values of the determination unit **38** shown in FIG. **7**. The determination unit **38** makes the enable signal EN valid when the amplitude of at least one of the in-phase signal GI and the quadrature signal GQ is greater than the threshold signal TH, while otherwise making the enable signal EN invalid.

Specifically, the determination unit **38** makes the enable signal EN invalid when the in-phase signal GI is in the range from a threshold value TI1 to a threshold value TI2, both inclusive, and the quadrature signal GQ is in the range from a threshold value TQ1 to a threshold value TQ2, both inclusive, (e.g., when the signal point of a symbol is a signal point SB), while otherwise (e.g., when the signal point of the symbol is a signal point SA) making the enable signal EN valid. In this embodiment, as an example, the threshold values TI2 and TQ2 are equal to the value of the threshold signal TH and the threshold values T11 and TQ1 are equal to -1 times as large as the value of the threshold signal TH.

The sum-of-square averaging unit **34** performs operation for obtaining the average of sum of squares on a current symbol when the enable signal EN is valid, while not performing the operation for obtaining the average of sum of squares on the symbol when the enable signal EN is invalid. Though signal points of symbols are concentrated around the origin of the complex plane in the presence of a reflected signal, the sum-of-square averaging unit **34** does not use symbols around the origin. Accordingly, even in the presence of a reflected signal, the average sum of squares calculated by the sum-of-square averaging unit **34** is not excessively small, as compared to the case where all the symbols are used. Thus, it is possible to prevent the gain of the negative feedback loop of the digital AGC device **26** from excessively increasing.

Since the sum-of-square averaging unit **34** does not use symbols around the origin of the complex plane, the average sum of squares calculated by the sum-of-square averaging unit **34** in the absence of a reflected signal is larger than that in the case where all the symbols are used. At this time, though the gain of the negative feedback loop of the digital AGC device **26** decreases, the demodulation performance after the digital AGC device **26** does not degrade so much because no reflected signal is present.

As described above, in this embodiment, it is possible to adjust the gain of the digital AGC device 26 with simple calculation so that the average amplitude of an output signal is allowed to be kept substantially constant independently of characteristics of the transmission channel.

The threshold value TI1 and the threshold value TQ1 in FIG. **8** may differ from each other. The threshold value TI2 and the threshold value TQ2 may also differ from each other.

The determination unit **38** may make the enable signal EN valid when the sum of the square of the in-phase signal GI and the square of the quadrature signal GQ is larger than the threshold signal TH, while otherwise making the enable signal EN invalid.

The threshold signal TH input to the determination unit 38 may be a fixed value or may be dynamically set from outside.

(EMBODIMENT 2)

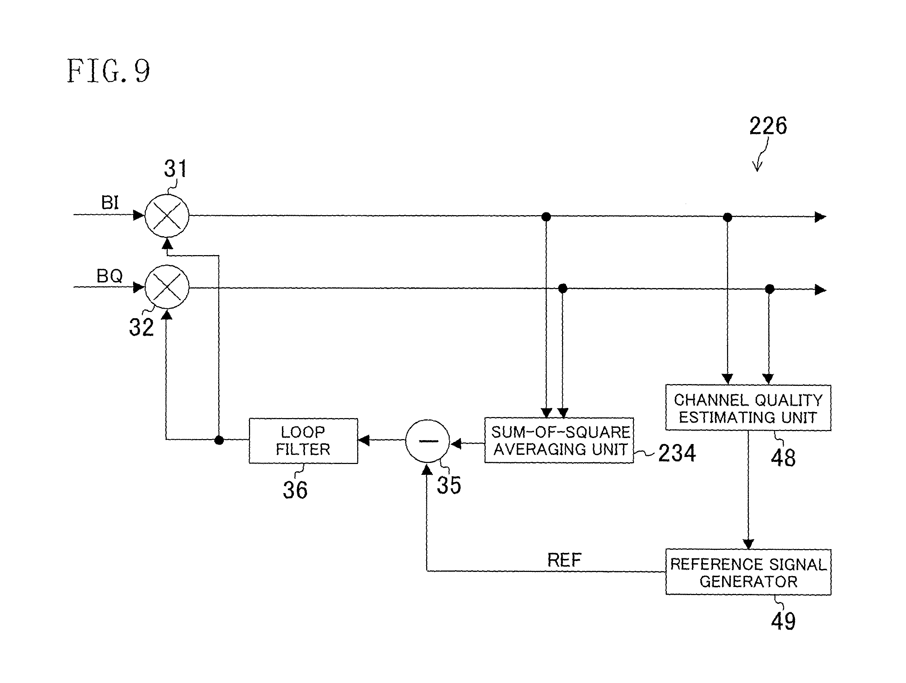

FIG. **9** is a block diagram showing a configuration of a digital AGC device **226** according to a second embodiment of the present invention. The digital AGC device **226** shown in FIG. **9** includes a first multiplier **31**, a second multiplier **32**, a sum-of-square averaging unit **234**, a subtractor **35**, a loop filter **36**, a channel quality estimating unit **48**, and a reference signal generator **49**. The digital AGC device **226** is used in the demodulator shown in FIG. **1** as a replacement of the digital AGC device 26 shown in FIG. **7**. The multipliers **31** and **32** and the loop filter **36** are the same as those shown in FIG. **7**, and thus detailed description thereof is not repeated.

The channel quality estimating unit **48** obtains a correlation value between a known data pattern and an actually-received data pattern as channel quality, based on an in-phase signal GI and a quadrature signal GQ output from the multipliers **31** and **32**, respectively. At this time, the channel quality estimating unit **48** obtains the correlation value in association with a reflected signal included in a received signal. For example, a VSB modulated signal conforming to the ATSC standard includes a known data pattern in a field sync segment.

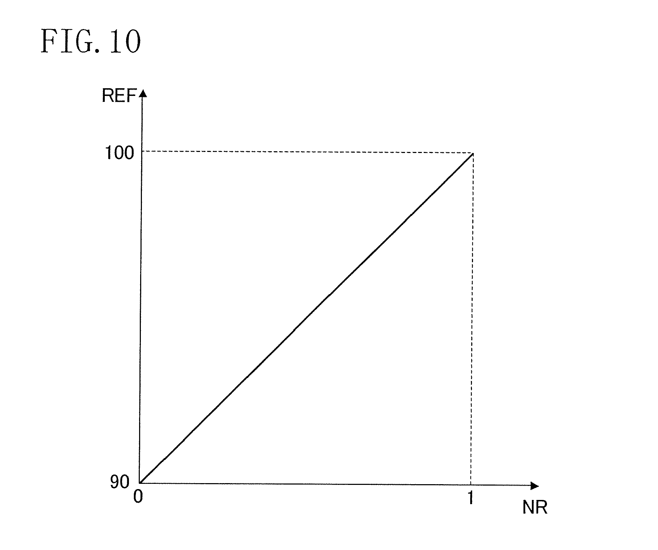

FIG. **10** is a graph for explaining generation of a reference signal REF. The reference signal generator **49** obtains a reference signal REF based on the difference between correlation values RM and R1 associated with a main signal and a reflected signal, respectively, and obtained by the channel quality estimating unit 48. Specifically, the reference signal generator **49** normalizes the difference between the correlation value RM and the correlation value R1 with the correlation value RM, thereby obtaining a normalized correlation-value difference: NR = (RM - RI)/RM. The normalized correlation-value difference NR is 1 (one) in the absence of a reflected signal, and is zero when one reflected signal is present and a main signal and the reflected signal have the same magnitude.

The reference signal generator **49** uses a value according to the normalized correlation-value difference NR as the reference signal REF. Specifically, in FIG. **10**, REF = 10 × NR + 90. That is, when the reflected signal is large, the reference signal REF has a small value. It should be noted that the relationship between the reference value REF and the normalized correlation-value difference NR shown in FIG. **10** is an example, and the reference value REF and the normalized correlation-value difference NR may have another relationship.

The sum-of-square averaging unit **234** squares each of the in-phase signal GI and the quadrature signal GQ, obtains the sum of these squares, averages the sum in terms of time, and outputs the averaged sum of squares to the subtractor **35**. The subtractor **35** reduces the reference signal REF from the averaged sum of squares, and outputs the obtained error to the loop filter **36**.

Although signal points of symbols are concentrated around the origin of the complex plane in the presence of a reflected signal, the reference signal generator **49** reduces the value of the reference signal REF. Accordingly, even in the presence of a reflected signal, the error output from the subtractor **35** is not excessively small. Thus, it is possible to prevent the gain of the negative feedback loop of the digital AGC device shown in FIG. **9** from excessively increasing.

On the other hand, in the absence of a reflected signal, the value of the reference signal REF is not excessively small so that demodulation performance after the digital AGC device shown in FIG. **9** does not degrade.

As described above, in the digital AGC device of this embodiment, the value of the reference signal REF is adaptively controlled so that it is possible to keep the average amplitude of an output signal substantially constant, independently of characteristics of a transmission channel.

The reference signal generator **49** may obtain the reference signal REF based on tap coefficients of a waveform equalizer.

The reference signal generator **49** may switch the value of the reference signal REF between the case of presence of a reflected signal and the case of absence of a reflected signal, and may have hysteresis characteristics in the switching operation.

The channel quality estimating unit 48 may select one of the outputs from the multipliers **31** and **32** to obtain channel quality based on the selected output.

In the foregoing embodiments, the 8-level VSB signal is processed as an example. Alternatively, another phase-modulated signal (e.g., an n-phase PSK signal), a multilevel quadrature amplitude modulated signal (e.g., an nQAM signal), or an n-level VSB signal may be processed.

INDUSTRIAL APPLICABILITY

As described above, the present invention prevents an excessive increase in signal amplitude even in the presence of a reflected signal, and is useful for, for example, a digital AGC device.

**Claims**

1. A digital AGC device, comprising:

   a first multiplier for multiplying an in-phase signal and a filter output signal together and outputting a result of the multiplication;
   a second multiplier for multiplying a quadrature signal and the filter output signal together and outputting a result of the multiplication;
   a determination unit for making an enable signal valid and outputting the enable signal when the outputs from the first and second multipliers satisfy a condition defined according to a threshold signal;
   a sum-of-square averaging unit for obtaining and outputting a time average of a sum of squares of the respective outputs from the first and second multipliers when the enable signal is valid;
   a subtractor for obtaining and outputting a difference between a reference signal and the operation result of the sum-of-square averaging unit; and
   a loop filter for smoothing the output from the subtractor and outputting the smoothed output as the filter output signal.

2. The digital AGC device of claim 1, wherein the determination unit makes the enable signal valid when an amplitude of at least one of the outputs from the first and second multipliers is greater than that of the threshold signal, whereas otherwise the determination unit makes the enable signal invalid.

3. The digital AGC device of claim 1, wherein the determination unit makes the enable signal valid when the sum of the squares of the respective outputs from the first and second multipliers is larger than the threshold signal, whereas otherwise the determination unit makes the enable signal invalid.

4. A digital AGC device, comprising:

a first multiplier for multiplying an in-phase signal and a filter output signal together and outputting a result of the multiplication;

a second multiplier for multiplying a quadrature signal and the filter output signal together and outputting a result of the multiplication;

a channel quality estimating unit for obtaining channel quality based on at least one of the outputs from the first and second multipliers;

a reference signal generator for generating a reference signal based on the channel quality;

a sum-of-square averaging unit for obtaining and outputting a time average of a sum of squares of the respective outputs from the first and second multipliers;

a subtractor for obtaining and outputting a difference between the reference signal and the operation result of the sum-of-square averaging unit; and

a loop filter for smoothing the output from the subtractor and outputting the smoothed output as the filter output signal.

5. The digital AGC device of claim 4, wherein the channel quality estimating unit obtains a correlation value between a known data pattern and a data pattern of a received signal as the channel quality, and
the reference signal generator obtains and outputs the reference signal according to the correlation value.

6. The digital AGC device of claim 5, wherein the reference signal generator has hysteresis characteristics in switching operation of switching the value of the reference signal between two values based on the correlation value.

7. The digital AGC device of claim 4, wherein the channel quality estimating unit selects one of the outputs from the first and second multipliers and obtains the channel quality based on the selected output.

FIG.1

12 AMPLIFIER

14 A/D CONVERTER

22 IQ DETECTOR

24 CARRIER WAVE/CLOCK RECOVERY UNIT

BI
BQ

26 DIGITAL AGC DEVICE

SYE

AMC

ANALOG AGC UNIT 28

# FIG. 2

| | | REFLECTED SIGNAL (WITH +1 SYMBOL DELAY) | | | | | | | |
|---|---|---|---|---|---|---|---|---|---|
| | | −7 | −5 | −3 | −1 | 1 | 3 | 5 | 7 |
| MAIN SIGNAL | −7 | −14 | −12 | −10 | −8 | −6 | −4 | −2 | 0 |
| | −5 | −12 | −10 | −8 | −6 | −4 | −2 | 0 | 2 |
| | −3 | −10 | −8 | −6 | −4 | −2 | 0 | 2 | 4 |
| | −1 | −8 | −6 | −4 | −2 | 0 | 2 | 4 | 6 |
| | 1 | −6 | −4 | −2 | 0 | 2 | 4 | 6 | 8 |
| | 3 | −4 | −2 | 0 | 2 | 4 | 6 | 8 | 10 |
| | 5 | −2 | 0 | 2 | 4 | 6 | 8 | 10 | 12 |
| | 7 | 0 | 2 | 4 | 6 | 8 | 10 | 12 | 14 |

EP 2 053 739 A1

FIG.3

| | | REFLECTED SIGNAL (WITH +1 SYMBOL DELAY) | | | | | | | |
|---|---|---|---|---|---|---|---|---|---|
| | | −7 | −5 | −3 | −1 | 1 | 3 | 5 | 7 |
| MAIN SIGNAL | −7 | −7 | −6 | −5 | −4 | −3 | −2 | −1 | 0 |
| | −5 | −6 | −5 | −4 | −3 | −2 | −1 | 0 | 1 |
| | −3 | −5 | −4 | −3 | −2 | −1 | 0 | 1 | 2 |
| | −1 | −4 | −3 | −2 | −1 | 0 | 1 | 2 | 3 |
| | 1 | −3 | −2 | −1 | 0 | 1 | 2 | 3 | 4 |
| | 3 | −2 | −1 | 0 | 1 | 2 | 3 | 4 | 5 |
| | 5 | −1 | 0 | 1 | 2 | 3 | 4 | 5 | 6 |
| | 7 | 0 | 1 | 2 | 3 | 4 | 5 | 6 | 7 |

FIG. 4

| | | REFLECTED SIGNAL (WITH +1 SYMBOL DELAY) | | | | | | | |
|---|---|---|---|---|---|---|---|---|---|
| | | 0 | 0 | 0 | 0 | 0 | 0 | 0 | 0 |
| MAIN SIGNAL | −7 | −7 | −7 | −7 | −7 | −7 | −7 | −7 | −7 |
| | −5 | −5 | −5 | −5 | −5 | −5 | −5 | −5 | −5 |
| | −3 | −3 | −3 | −3 | −3 | −3 | −3 | −3 | −3 |
| | −1 | −1 | −1 | −1 | −1 | −1 | −1 | −1 | −1 |
| | 1 | 1 | 1 | 1 | 1 | 1 | 1 | 1 | 1 |
| | 3 | 3 | 3 | 3 | 3 | 3 | 3 | 3 | 3 |
| | 5 | 5 | 5 | 5 | 5 | 5 | 5 | 5 | 5 |
| | 7 | 7 | 7 | 7 | 7 | 7 | 7 | 7 | 7 |

EP 2 053 739 A1

FIG. 5

FIG. 6

FIG.7

FIG.8

FIG.9

226

BI — ⊗ 31

BQ — ⊗ 32

LOOP FILTER 36

⊖ 35

SUM-OF-SQUARE AVERAGING UNIT 234

CHANNEL QUALITY ESTIMATING UNIT 48

REFERENCE SIGNAL GENERATOR 49

REF

EP 2 053 739 A1

FIG. 10

# INTERNATIONAL SEARCH REPORT

| | International application No. |
|---|---|
| | PCT/JP2007/073608 |

**A. CLASSIFICATION OF SUBJECT MATTER**
*H03G3/20*(2006.01)i, *H03G3/30*(2006.01)i

According to International Patent Classification (IPC) or to both national classification and IPC

**B. FIELDS SEARCHED**

Minimum documentation searched (classification system followed by classification symbols)
H03G3/20, H03G3/30

Documentation searched other than minimum documentation to the extent that such documents are included in the fields searched
Jitsuyo Shinan Koho        1922-1996   Jitsuyo Shinan Toroku Koho   1996-2008
Kokai Jitsuyo Shinan Koho   1971-2008   Toroku Jitsuyo Shinan Koho   1994-2008

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 06-216954 A  (NEC Corp.), 05 August, 1994 (05.08.94), Par. Nos. [0002] to [0006]; Fig. 5 & AU 5386594 A   & EP 607944 A1 & JP 06-216955 A   & US 5452332 A & AU 673390 B   & CN 1099207 A & EP 607944 B1   & DE 69413264 E & CN 1052591 C | 1-7 |
| Y | JP 2001-230690 A  (Hitachi Kokusai Electric Inc.), 24 August, 2001 (24.08.01), Par. Nos. [0001] to [0044]; Fig. 1 (Family: none) | 1-3 |

☒ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 03 March, 2008 (03.03.08) | 11 March, 2008 (11.03.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

| International application No. |
|---|
| PCT/JP2007/073608 |

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2001-024454 A  (Matsushita Electric Industrial Co., Ltd.), 26 January, 2001 (26.01.01), Par. Nos. [0051] to [0059]; Fig. 3 & EP 1067681 A2          & CN 1280417 A & US 6577852 B1          & CN 1197238 C | 1-3 |
| Y | JP 2006-148735 A  (Matsushita Electric Industrial Co., Ltd.), 08 June, 2006 (08.06.06), Par. Nos. [0024] to [0027]; Figs. 10, 11 (Family: none) | 1-3 |
| Y | JP 2006-050585 A  (Sharp Corp.), 16 February, 2006 (16.02.06), Par. Nos. [0002] to [0010]; Fig. 8 (Family: none) | 4-7 |
| Y | JP 2001-102947 A  (Toshiba Corp.), 13 April, 2001 (13.04.01), Par. Nos. [0025] to [0049], [0072]; Figs. 1, 3 & CN 1293493 A          & US 6650878 B1 & CN 1133279 C          & JP 3710658 B2 & EP 1089429 B1          & DE 60024196 E & DE 60024196 T2          & EP 1089429 A2 | 5,6 |

Form PCT/ISA/210 (continuation of second sheet) (April 2007)

**EP 2 053 739 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2237207 A